# EUROPÄISCHE PATENTSCHRIFT

(11) **EP 3 317 686 B1**
(45) Veröffentlichungstag und Bekanntmachung des Hinweises auf die Patenterteilung: **23.03.2022**
(21) Anmeldenummer: 16741248.5
(22) Anmeldetag: 01.07.2016
(51) Int. Cl.: G01R 33/12, G01R 27/26

(54) **VORRICHTUNG ZUR ÜBERWACHUNG EINES MAGNETKERNS UND VERFAHREN ZUR ERFASSUNG EINES SÄTTIGUNGSVERHALTENS EINES ZU ÜBERWACHENDEN MAGNETKERNS**
APPARATUS FOR MONITORING A MAGNETIC CORE AND METHOD FOR DETECTING A SATURATION BEHAVIOUR OF A MAGNETIC CORE TO BE MONITORED
DISPOSITIF DE SURVEILLANCE D'UN NOYAU MAGNÉTIQUE ET PROCÉDÉ DE DÉTECTION D'UN COMPORTEMENT DE SATURATION D'UN NOYAU MAGNÉTIQUE SURVEILLÉ

(30) Priorität: 03.07.2015 DE 102015212497
(43) Veröffentlichungstag der Anmeldung: 09.05.2018
(73) Patentinhaber: SUMIDA Components & Modules GmbH, 94130 Obernzell (DE)
(72) Erfinder: JUNGWIRTH, Herbert, 94051 Hauzenberg (DE)
(74) Vertreter: Grünecker Patent- und Rechtsanwälte PartG mbB
(86) Internationale Anmeldenummer: PCT/EP2016/065500
(87) Internationale Veröffentlichungsnummer: WO 2017/005624

(56) Entgegenhaltungen:
- WO-A1-2014/080609
- CH-A2- 707 221
- DE-A1- 3 637 801
- US-A1- 2014 218 012

## Beschreibung

### Gebiet der Erfindung

Die Erfindung betrifft im Allgemeinen eine Vorrichtung zur Überwachung eines Magnetkerns, und ein Verfahren zur Erfassung eines Sättigungsverhaltens eines zu überwachenden Magnetkerns. Die Erfindung betrifft insbesondere die Überwachung des Sättigungsverhaltens eines zu überwachenden Magnetkerns.

### Hintergrund

In induktiven Bauelementen, wie zum Beispiel Drosseln und Transformatoren, werden häufig Magnetkerne vorgesehen, um Induktivitätswerte zu erreichen, die ansonsten in Luftspulen (d.h. Spulen ohne Kern) nur mit vergleichsweise hohen Windungszahlen erreichbar wären und damit wiederum sehr hohe Ohm'sche Widerstände ergeben würden. Die mit Hilfe eines Magnetkerns bei relativ geringen Windungszahlen erreichbaren großen Induktivitäten können ferner durch die Wahl eines geeigneten Kernmaterials noch verbessert werden. Dabei wird die Permeabilitätszahl, also der Faktor der Induktivitätserhöhung, mittels eines geeigneten Materials gezielt eingestellt. Anwendungen von induktiven Bauelementen mit Magnetkern umfassen z.B. Leistungsanwendungen und Konverter für Brennstoffzellen und Photovoltaik-Anlagen.

Im Allgemeinen ist für induktive Bauelemente mit Magnetkern eine gute Umwandlung von elektrischer Energie in magnetische Energie und umgekehrt erwünscht. Beispielsweise wird in Spulen von Drosseln und Transformatoren durch den Magnetkern eine sehr effiziente Umwandlung der elektrischen Energie in magnetische Energie und umgekehrt erreicht, da der Magnetkern eine stark ansteigende magnetische Flussdichte bei Anlegen eines äußeren Magnetfelds zeigt. Der Grund liegt darin, dass die Magnetisierung eines Materials bei Anlegen eines äußeren Magnetfelds solange erhöht wird, bis sich mikroskopisch kleine magnetisierte Domänen im Magnetkern, die sogenannten Weiss-Bezirke, zu einem Weiss-Bezirk vergrößert haben, der sich über den gesamten Magnetkern erstreckt. Als Folge kann die Magnetisierung eines gesättigten Magnetkerns bei einer Vergrößerung des anliegenden äußeren Magnetfelds nicht mehr weiter erhöht werden und die magnetische Flussdichte im Magnetkern steigt nur noch sehr langsam an. Mit anderen Worten, die magnetische Permeabilität des Magnetkerns nähert sich bei Sättigung des Kerns dem Wert µ = 1 (d.h. der Permeabilität des Vakuums) an.

Induktive Bauelemente mit einem in die Sättigung gehenden Magnetkern führen in zahlreichen technischen Anwendungen zu Nachteilen im Betrieb. Beispielsweise sinkt in einem Transformator die Effizienz der Umwandlung von elektrischer in magnetische Energie und umgekehrt, wenn der Kern in Sättigung geht, so dass der Wirkungsgrad des Transformators erheblich verringert wird. Auch bei Drosseln ist das Auftreten einer Sättigung im Kern unerwünscht, da sich hier das Vermögen einer Drossel zur zeitweisen Speicherung von Energie in Form eines Magnetfelds drastisch verringert. Insbesondere im Zuge von Miniaturisierungen verringern sich Sättigungsgrenzen zu kleineren Strömen und Feldern hin.

Eine Möglichkeit die mit der Sättigung einhergehenden nachteiligen Effekte zu verhindern besteht darin, das Eintreten einer Sättigung zu einem späteren Zeitpunkt, d.h. bei höheren angelegten äußeren Magnetfeldern bzw. höheren Strömen, zu verschieben, wie z.B. mittels eines in einen Magnetkern geschnitten Luftspalts erreicht werden kann. Aufgrund des Luftspalts im Kern erfolgt eine langsamere Zunahme der magnetischen Flussdichte im Magnetkern, so dass die magnetische Sättigung erst später (d.h. bei höheren äußeren Feldern) eintritt. Der Grund hierfür ist, dass der Luftspalt gegenüber dem Magnetkern einen wesentlich höheren magnetischen Widerstand aufweist und die Magnetisierung des Materials im Magnetkern effektiv behindert wird. Folglich steigt die Magnetisierung eines Magnetkerns vergleichsweise langsamer an. Da der langsame Anstieg der Magnetisierung über einen vergleichsweise größeren Bereich proportional zum angelegten äußeren Feld ist, bedeutet dies für viele Anwendungen nur eine ungenügende Verstärkung des an den Magnetkern von außen angelegten Felds.

Im Allgemeinen werden induktive Bauelemente in einem Bereich betrieben, in dem sichergestellt ist, dass der Kern nicht in Sättigung geht. Da Sättigungsbereiche in der Herstellung von Magnetkernen aufgrund von Prozessschwankungen nicht genau einkalkulierbar sind, müssen niedrigere Grenzen für äußere Felder bzw. Betriebsströme angesetzt werden, um das unerwünschte Auftreten von Sättigung während des Betriebs auszuschließen. Dies führt jedoch zu einer starken Begrenzung der Aussteuerbarkeit eines induktiven Bauelements.

Dokument CH 707 221 A2 zeigt eine Messvorrichtung zur Induktivitätsmessung bei der Messung einer magnetischen Flussdichte oder einer magnetischen Sättigung in einem induktiven Element, wobei das induktive Element einen Hauptkern mit mindestens einer Hauptwicklung zum Erzeugen eines Magnetfeldes im Hauptkern aufweist. Die Messvorrichtung weist ferner einen vom Hauptkern verschiedenen ersten Messkern mit einer ersten Messwicklung zum Erzeugen eines Magnetfeldes im ersten Messkern, eine Messvorrichtung und eine Messsignalquelle auf, welche zum Erzeugen einer periodisch wechselnden ersten Messspannung über der ersten Messwicklung angeordnet ist auf. Außerdem weist die Messvorrichtung einen Stromwandler, der zum Bilden eines ersten Messstroms, welcher proportional zum Strom durch die erste Messwicklung ist, angeordnet ist, und einen Messgleichrichter auf, der zum Gleichrichten des ersten Messstroms und Erfassen eines Messsignales entsprechend dem gleichgerichteten ersten Messstrom angeordnet ist. Hierbei überlagern sich ein von der Hauptwicklung erzeugter magnetischer Fluss und ein von der ersten Messwicklung erzeugter magnetischer Fluss in mindestens einem Teilbereich des Hauptkernes und/oder des ersten Messkernes überlagern.

Es besteht daher die Aufgabe, Verluste in der Aussteuerung von induktiven Bauelementen möglichst gering zu halten.

### Zusammenfassung

Die oben genannten Probleme werden gelöst durch eine Vorrichtung zur Überwachung eines Magnetkerns und ein Verfahren zur Erfassung eines Sättigungsverhaltens eines zu überwachenden Magnetkerns, wodurch es möglich ist, weniger stringente Grenzen für Sättigungsströme festzulegen. Insbesondere wird ein "intelligentes Bauelement" bereitgestellt, in dem eine optimale Aussteuerung durch eine Überwachung bzw. Bestimmung eines Sättigungsverhaltens eines zu überwachenden Magnetkerns ermöglicht wird.

In einem ersten Aspekt der vorliegenden Erfindung wird eine Vorrichtung zur Überwachung eines Magnetkerns bereitgestellt, wobei die Vorrichtung eine mit dem zu überwachenden Magnetkern magnetisch gekoppelte Messwicklung, eine zu der Wicklung elektrisch in Reihe geschaltete Vergleichsinduktivität und eine elektronische Verarbeitungseinheit bereitgestellt wird, die zur Bestimmung des Sättigungsverhaltens des zu überwachenden Magnetkerns ausgebildet ist. Die elektronische Verarbeitungseinheit ist weiterhin dazu konfiguriert, ein an der Messwicklung auftretendes erstes elektrisches Signal und ein an der Vergleichsinduktivität auftretendes zweites elektrisches Signal in Antwort auf ein an die Messwicklung und an die Vergleichsinduktivität angelegtes elektrisches Messsignal zu erfassen und das Sättigungsverhalten des zu überwachenden Magnetkerns auf Grundlage des ersten und zweiten elektrischen Signals zu bestimmen. Dadurch kann das Sättigungsverhalten eines Magnetkerns auf einfache Weise überwacht und das Auftreten einer Sättigung des Magnetkerns zuverlässig erfasst werden.

In einer anschaulichen Ausführungsform des ersten Aspekts kann die elektronische Verarbeitungseinheit ferner dazu ausgebildet sein, einen Quotienten aus dem ersten elektrischen Signal und dem zweiten elektrischen Signal zu bestimmen. Dies stellt eine auf einfache Weise realisierbare Überwachung dar, wobei z.B. die elektronische Verarbeitungseinheit gemäß einem analogen Schaltschema mit Operationsverstärkern eine Quotientenschaltung umfassen kann.

In einer vorteilhaften Ausgestaltung hierin kann die elektronische Verarbeitungseinheit ferner dazu ausgebildet sein, eine Änderung im Quotienten um mehr als 10 % von einem konstanten Wert des Quotienten, vorzugsweise um mehr als 5 % oder auch mehr als 1 %, mit einer Sättigung des zu überwachenden Magnetkerns zu identifizieren. Dies stellt ein sehr einfaches Kriterium zur Bestimmung des Sättigungsverhaltens des zu überwachenden Magnetkerns bereit.

In einer weiteren anschaulichen Ausführungsform der Erfindung kann das erste elektrische Signal eine über der Messwicklung abfallende Spannung sein und/oder das zweite elektrische Signal kann eine über die Vergleichsinduktivität abfallende Spannung sein. Dies stellt elektrische Signale dar, die auf einfache Weise zu messen und weiterzuverarbeiten sind.

In einer weiteren anschaulichen Ausführungsform der Erfindung kann die Vergleichsinduktivität einen von dem zu überwachenden Magnetkern verschiedenen weiteren Magnetkern aufweisen. Dadurch lässt sich ein flexibler Aufbau erreichen, wobei Magnetkerne auf einfache Weise mit der Vergleichsinduktivität nachgerüstet werden können.

In einer vorteilhaften Ausgestaltung dieser Ausführungsform kann der weitere Magnetkern einen Sättigungsstrom aufweisen, der größer ist als ein Sättigungsstrom des zu überwachenden Magnetkerns. Damit wird effizient verhindert, dass das Sättigungsverhalten des zu überwachenden Magnetkerns durch den weiteren Magnetkern nachteilig beeinflusst wird.

In einer weiteren vorteilhaften Ausgestaltung dieser Ausführungsform kann die Vergleichsinduktivität als Stromwandler ausgebildet sein. Dies stellt eine einfache Weise zur Bereitstellung einer Vergleichsinduktivität dar.

In einer weiteren vorteilhaften Ausgestaltung dieser Ausführungsform kann der weitere Magnetkern mit dem zu überwachenden Magnetkern verbunden sein und es kann eine in dem zu überwachenden Magnetkern durch die Vergleichsinduktivität induzierte magnetische Flussdichte senkrecht zu einer von der Messwicklung in dem zu überwachenden Kern induzierten magnetischen Flussdichte orientiert sein. Dadurch wird eine nachteilige Beeinflussung der Messwicklung durch die Vergleichsinduktivität unterbunden.

In einem zweiten Aspekt der Erfindung wird ein Verfahren zur Erfassung eines Sättigungsverhaltens eines zu überwachenden Magnetkerns mit einer Messwicklung bereitgestellt, wobei das Verfahren ein Anlegen eines elektrischen Messsignals an die Messwicklung, ein Erfassen eines ersten elektrischen Signals an der Messwicklung in Antwort auf das elektrische Messsignal, ein Erfassen eines zweiten elektrischen Signals an einer mit der Messwicklung elektrisch in Reihe geschalteten Vergleichsinduktivität in Antwort auf das elektrische Messsignal und ein Bestimmen des Sättigungsverhaltens des zu überwachenden Magnetkerns auf Grundlage der ersten und zweiten elektrischen Signale umfasst. Hierdurch wird das Sättigungsverhalten eines Magnetkerns auf einfache Weise überwacht und das Auftreten einer Sättigung des Magnetkerns zuverlässig erfasst.

In einer anschaulichen Ausführungsform hierin kann das erste elektrische Signal als eine über der Messwicklung abfallende elektrische Spannung und/oder das zweite elektrische Signal als eine über der Vergleichsinduktivität abfallende elektrische Spannung erfasst werden. Dies stellt eine einfache Weise zur Erfassung und Weiterverarbeitung der elektrischen Signale dar.

In einer weiteren anschaulichen Ausführungsform der Erfindung kann das Sättigungsverhalten auf Grundlage eines Quotienten aus dem ersten elektrischen Signal und dem zweiten elektrischen Signal bestimmt werden. Dies erlaubt eine einfache Bestimmung des Sättigungsverhaltens durch die ersten und zweiten elektrischen Signale.

In einer vorteilhaften Ausgestaltung dieser Ausführungsform kann eine Sättigung des zu überwachenden Magnetkerns mit einer Änderung im Quotienten um mehr als 10 % von einem konstanten Wert des Quotienten, beispielsweise mehr als 5 % oder um mehr als 1 %, identifiziert werden. Dies stellt ein einfaches Kriterium zur Bestimmung des Sättigungsverhaltens dar.

In einer weiteren vorteilhaften Ausgestaltung dieser Ausführungsform kann das elektrische Messsignal ein Stromsignal sein und der Quotient kann in Abhängigkeit des Stromsignals erfasst werden, wobei das Verfahren ferner ein Bilden eines Produkts aus dem Stromsignal und dem Quotienten und ein Bestimmen eines Sättigungsstroms aus einem lokalen Maximum in einem Zusammenhang zwischen dem Produkt und dem Stromsignal umfassen kann. Dies stellt ein weiteres effizientes Kriterium zur Bestimmung des Sättigungsverhaltens eines zu überwachenden Magnetkerns dar.

In einer weiteren vorteilhaften Ausgestaltung dieser Ausführungsform kann das elektrische Messsignal ein Stromsignal sein und der Quotient kann in Abhängigkeit des Stromsignals erfasst werden, wobei das Verfahren ferner ein Bilden eines Produkts aus einem Quadrat des Stromsignals und dem Quotienten und ein Bestimmen eines Sättigungsstroms aus einem lokalen Maximum in einem Zusammenhang zwischen dem Produkt und dem Stromsignal umfassen kann. Dies stellt ein effizientes Verfahren zur Bestimmung eines Sättigungsverhaltens eines zu überwachenden Magnetkerns dar.

In einem dritten Aspekt der Erfindung wird eine Verwendung der Vorrichtung nach dem oben beschriebenen ersten Aspekt in einer Leistungsanwendung oder mit einem Konverter bereitgestellt, wobei der zu überwachenden Magnetkern mit einer darüber gebildeten Wicklung eine Induktivität in der Leistungsanwendung oder im Konverter bildet. Damit wird während eines Normalbetriebs einer Induktivität in einer Leistungsanwendung oder in einem Konverter, z.B. von einer Brennstoffzelle oder einer Photovoltaik-Anlage, der Magnetkern der Induktivität überwacht. Es kann folglich eine maximale Aussteuerung der Induktivität während des Normalbetriebs erfolgen, die unabhängig von vorgegebenen Parametern ist, da die Induktivität direkt während des Betriebs überwacht wird und eine Abweichung in der Induktivität zuverlässig erkannt werden kann, so dass rechtzeitig geeignete Maßnahmen ergriffen werden können, bspw. um eine ausgeprägtes Sättigungsverhalten des Magnetkerns zu unterdrücken.

### Kurze Beschreibung der Figuren

Weitere vorteilhafte und anschauliche Aspekte und Ausführungsformen der vorliegenden Erfindung gehen aus der nachfolgenden Beschreibung hinsichtlich der beiliegenden Figuren hervor, wobei
- Fig. 1a: schematisch ein induktives Bauelement mit einer Vorrichtung zur Überwachung eines Magnetkerns darstellt;
- Fig. 1b: schematisch ein induktives Bauelement mit einer Vorrichtung zur Überwachung eines Magnetkerns gemäß einer weiteren anschaulichen Ausführungsform der Erfindung darstellt;
- Fig. 2a: schematisch einen Zusammenhang zwischen einem Quotienten zweier elektrischer Signale und einem Stromsignal gemäß einiger anschaulicher Ausführungsformen der Erfindung darstellt;
- Fig. 2b: schematisch einen Zusammenhang zwischen einem Stromsignal und einem Produkt aus dem Quotienten und dem Stromsignal gemäß einiger anschaulicher Ausführungsformen der vorliegenden Erfindung darstellt;
- Fig. 2c: schematisch einen Zusammenhang zwischen einem Stromsignal und einem Produkt aus dem Quotienten und dem Quadrat des Stromsignals gemäß einiger anschaulicher Ausführungsformen der vorliegenden Erfindung darstellt; und
- Fig. 3: schematisch in einer perspektivischen Ansicht eine Vorrichtung zur Überwachung eines Magnetkerns gemäß einiger anschaulicher Ausführungsformen der Erfindung darstellt.

### Detaillierte Beschreibung einiger anschaulicher Ausführungsformen

In verschiedenen anschaulichen Ausführungsformen der Erfindung wird das Sättigungsverhalten eines Magnetkerns durch eine mit dem zu überwachenden Magnetkern gekoppelte Messwicklung und eine zur Messwicklung in Reihe geschaltete Vergleichsinduktivität überwacht. Der Eintritt in die Sättigung des überwachenden Magnetkerns kann dabei anhand von wenigstens einem Messsignal bestimmt werden, wobei das Messsignal an der Messwicklung abgegriffen wird. In einem nicht beschränkenden einfachen Beispiel kann der Quotient aus einer über der Vergleichsinduktivität abfallenden Spannung und einer über der Messwicklung abfallenden Spannung gebildet werden, wobei der Quotient solange konstant ist, wie der zu überwachende Magnetkern nicht bedeutend in Sättigung geht. Eine zunehmende Sättigung des zu überwachenden Magnetkerns führt zu einer zunehmenden Abweichung des Quotienten vom konstanten Wert, so dass bei Überschreitung der Abweichung in einem bestimmten Maße eine Sättigung des zu überwachenden Magnetkerns bezeichnet.

In einigen beispielhaften Ausführungsformen kann ein elektrischer Betrieb eines induktiven Bauelements überwacht und gesteuert werden, wobei das induktive Bauelement den zu überwachenden Magnetkern umfasst. Beispielsweise kann ein Strom durch das induktive Bauelement abhängig von dem Sättigungsverhalten des zu überwachenden Kerns gesteuert werden, etwa dahingehend, dass proportional zu einer Abweichung des Quotienten von einem konstanten Wert bzw. proportional zu einem Vergleich des Quotienten mit einem vorgegebenen Wert, der Stromfluss durch das induktive Bauelement verringert wird. Dies kann direkt oder indirekt über eine den Betrieb des induktiven Bauelements steuernden und/oder überwachende Steuerung erreicht werden.

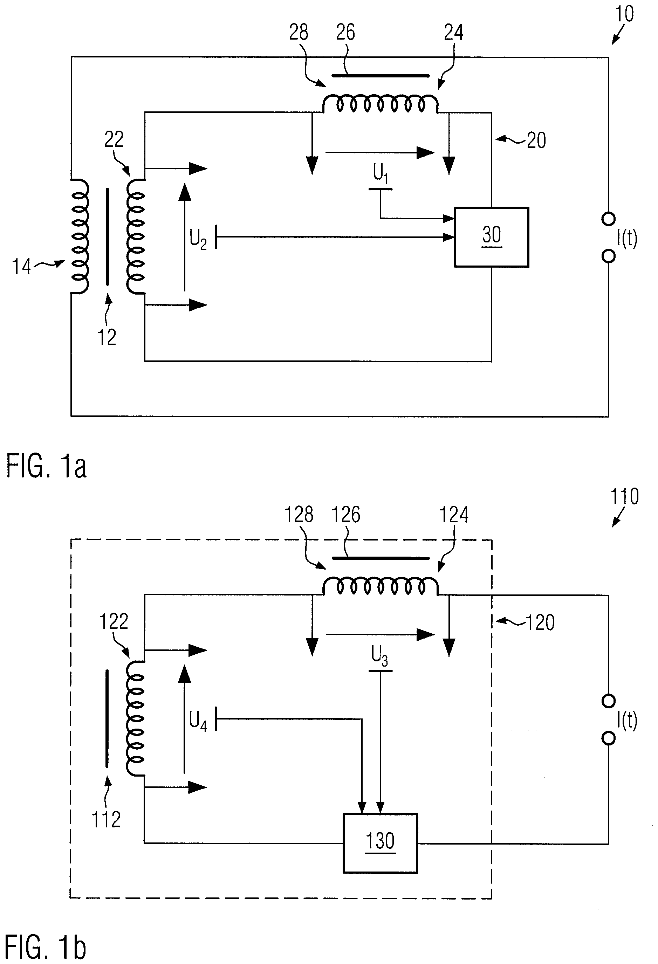

Beispielhafte Ausführungsformen sind nun nachstehend hinsichtlich der Figuren 1 bis 3 beschrieben.

Fig. 1a zeigt schematisch ein induktives Bauelement 10, das einen zu überwachenden Magnetkern 12 und eine an dem Magnetkern angeordnete Wicklung 14 umfasst. Das induktive Bauelement 10 kann z.B. für Leistungsanwendungen oder als Konverter für eine Brennstoffzelle oder für Photovoltaik-Anwendungen vorgesehen sein.

Zur Überwachung des Magnetkerns 12 ist eine Vorrichtung 20 vorgesehen, die eine Messwicklung 22 und eine mit der Messwicklung elektrisch in Reihe geschaltete Vergleichsinduktivität 24 umfasst. Die Vorrichtung zur Überwachung des Magnetkerns 12 weist ferner eine elektronische Verarbeitungseinheit 30 auf, die zur Bestimmung des Sättigungsverhaltens des zu überwachenden Magnetkerns 12 ausgebildet ist.

In einer beispielhaften Ausführungsform wird die Vergleichsinduktivität 24 durch eine Wicklung 28 und einen Magnetkern 26 gebildet, wobei sich der Magnetkern 26 von dem zu überwachenden Magnetkern 12 unterscheidet. Gemäß einiger anschaulicher Beispiele ist der Magnetkern 26 von dem zu überwachenden Magnetkern 12 magnetisch entkoppelt, d.h. eine von der Wicklung 28 im Magnetkern 26 induzierte magnetische Flussdichte induziert in der Messwicklung 22 keine Spannung. Dies bedeutet, dass eine in der Wicklung 22 durch die Wicklung 28 induzierte Spannung insbesondere geringer ist als 20 % einer Spannung, die durch die Wicklung 14 in der Messwicklung 22 induziert wird. Eine durch die Wicklung 28 in der Wicklung 22 induzierte Spannung kann z.B. kleiner als 10 % oder kleiner als 5 % oder kleiner als 1 % von der in der Messwicklung 22 durch die Wicklung 14 induzierten Spannung sein.

Die elektronische Verarbeitungseinheit 30 ist mit der Messwicklung 22 und der Vergleichsinduktivität 24 gekoppelt, so dass ein an der Messwicklung 22 auftretendes elektrisches Signal, beispielsweise eine über der Messwicklung 22 abfallende Spannung U₂, oder ein an der Vergleichsinduktivität 24 auftretendes elektrisches Signal, z.B. eine über der Vergleichsinduktivität 24 abfallende Spannung U₁, erfasst und der elektronischen Verarbeitungseinheit zugeführt wird. Gemäß einiger beispielhafter Ausführungsformen weist die elektronische Verarbeitungseinheit 30 dazu wenigstens eine Messvorrichtung (nicht dargestellt) auf, um elektrische Signale an der Messwicklung 22, wie z.B. die Spannungen U₂ über der Messwicklung 22, und/oder an der Vergleichsinduktivität 24, wie z.B. die Spannung U₁ über der Vergleichsinduktivität 24, zu erfassen und an die elektronische Verarbeitungseinheit 30 zu übermitteln. Die elektronische Verarbeitungseinheit 30 kann ferner eine Strom- oder Spannungsquelle (nicht dargestellt) aufweisen und/oder Strom- bzw. Spannungsmessgeräte umfassen.

Gemäß der Darstellung in Fig. 1a kann das induktive Bauelement 10 mit einer Stromquelle verbunden sein, so dass ein Stromsignal I(t) an die Wicklung 14 angelegt wird. Die elektronische Verarbeitungseinheit 30 kann beispielsweise dazu ausgelegt sein, das von der Wicklung 14 über den Magnetkern 12 auf die Messwicklung 22 übertragene Stromsignal I(t) zu erfassen. Alternativ kann die elektronische Verarbeitungseinheit 30 an die Messwicklung 22 und/oder an die Vergleichsinduktivität 24 ein Messsignal anlegen, wie z.B. ein Stromsignal, das durch die elektronische Verarbeitungseinheit 30 ausgegeben wird, und die in Antwort auf das ausgegebene Messsignal an der Messwicklung 22 auftretende elektrische Signal, beispielsweise die über der Messwicklung 22 abfallende Spannung U₂, und das an der Vergleichsinduktivität 24 auftretende elektrische Signal, z.B. die über der Wicklung 28 abfallende Spannung U₁, erfassen. Anstelle des Stromsignals I(t) kann ein Spannungssignal (nicht dargestellt) als Messsignal angelegt werden.

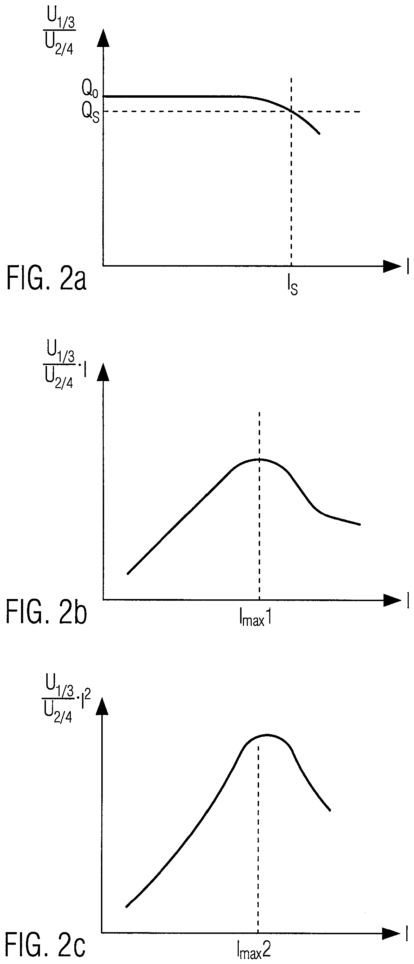

Gemäß anschaulichen Ausführungsformen ist die elektronische Verarbeitungseinheit dazu konfiguriert, das Sättigungsverhalten des zu überwachenden Magnetkerns 12 zu bestimmen und insbesondere das Sättigungsverhalten des zu überwachenden Magnetkerns 12 auf Grundlage von an der Messwicklung 22 und der Vergleichsinduktivität 24 auftretenden elektrischen Signale, beispielsweise der über der Messwicklung 22 abfallenden Spannung U₂ und der über der Wicklung 28 der Vergleichsinduktivität 24 abfallenden Spannung U₁, zu bestimmen. Details hinsichtlich einer Bestimmung des Sättigungsverhaltens gemäß einiger anschaulicher Ausführungsformen der Erfindung werden weiter unten hinsichtlich der Fig. 2a bis 2c detaillierter beschrieben. Alternativ kann anstelle der abfallenden Spannung U₁ und/oder U₂ ein durch die Messwicklung 22 und/oder durch die Vergleichsinduktivität fließender Strom als erstes und/oder zweites Signal gemessen werden.

In einem anschaulichen Beispiel wird die Vergleichsinduktivität 24 durch einen Stromwandler bereitgestellt, wobei ein an das induktive Bauelement 10 angelegtes Stromsignal potenzialfrei auf die Vorrichtung 20 übertragen wird. Hierbei können große Stromsignale I(t) potenzialfrei gemessen werden.

Gemäß beispielhafter Ausführungsformen der Erfindung ist ein Sättigungsstrom des Kerns 26 der Vergleichsinduktivität 24 sehr hoch. Hierin ist insbesondere ein Sättigungsstrom des Kerns 26 der Vergleichsinduktivität 24 größer als ein Sättigungsstrom, der für den zu überwachenden Magnetkern 12 zu erwarten ist. Gemäß anschaulicher Beispiele kann ein Sättigungsstrom des Magnetkerns 26 mehr als doppelt so groß sein wie ein zu erwartender Sättigungsstrom des zu überwachenden Magnetkerns 12. In speziellen Beispielen kann der Sättigungsstrom des Magnetkerns 26 mehr als 5 mal oder mehr als 10 mal so groß sein wie ein Sättigungsstrom des zu überwachenden Magnetkerns 12.

In Fig. 1b ist eine alternative Ausführungsform der Erfindung gezeigt. Es sind ein induktives Bauelement 110, eine Vorrichtung 120 zur Überwachung eines Magnetkerns 112 und eine über dem Magnetkern 112 angebrachte Wicklung 122 dargestellt. Der Magnetkern 112 mit Wicklung 122 kann z.B. eine Drossel für Leistungsanwendungen oder wenigstens teilweise einen Konverter für Photovoltaik-Anwendungen oder Brennstoffzellen darstellen.

Die Vorrichtung 120 umfasst ferner eine zu der Wicklung 122 elektrisch in Reihe geschaltete Vergleichsinduktivität 124, die durch einen Magnetkern 126 und eine Wicklung 128 gebildet wird, wobei sich der Magnetkern 126 von dem zu überwachenden Magnetkern 112 unterscheidet. Die Vorrichtung 120 umfasst ferner eine elektronische Verarbeitungseinheit 130, die zur Erfassung elektrischer Signale in Antwort auf ein Messsignal, wie z.B. ein Stromsignal I(t), ausgebildet ist. In dem dargestellten Beispiel ist die elektronische Verarbeitungseinheit 130 dazu konfiguriert, elektrische Signale, die an der Wicklung 122 und an der Vergleichsinduktivität 124 auftreten, durch Messeinrichtungen (nicht dargestellt) zu messen, wie z.B. eine über der Wicklung 122 abfallende Spannung U₄ und eine über der Wicklung 128 abfallende Spannung U₃ (alternativ einen entsprechenden Strom/entsprechende Ströme). Die an der Wicklung 122 und an der Vergleichsinduktivität 124 auftretenden elektrischen Signale werden an die elektronische Verarbeitungseinheit übermittelt und/oder von dieser erfasst.

Die in Fig. 1b dargestellte Ausführungsform unterscheidet sich von der in Fig. 1a dargestellten Ausführungsform darin, dass die Vorrichtung 120 direkt in das induktive Bauelement 110 eingebaut ist, und insbesondere damit galvanisch gekoppelt ist. Demgegenüber ist die Vorrichtung 20 in Fig. 1a von der Wicklung 14 galvanisch entkoppelt.

Mit Bezug auf die Fig. 2a bis 2c werden Details zur Bestimmung des Sättigungsverhaltens eines zu überwachenden Magnetkerns (vgl. beispielsweise Magnetkern 12 in Fig. 1a oder Magnetkern 112 in Fig. 1b) gemäß unterschiedlicher anschaulicher Ausführungsformen beschrieben. Es sei daran erinnert, dass für eine von einer Induktivität induzierte Spannung gilt: U(t) = L * (-dl/dt), wobei L die Induktivität in Henry bezeichnet und I ein Stromsignal darstellt (dl/dt bezeichnet die zeitliche Ableitung von I). Es gilt also, dass eine Induktivität die Änderung des Stroms I bei Anlegen der Spannung U(t) begrenzt.

Wird nun die Induktivität der Vergleichsinduktivität 24 in Fig. 1a bzw. 124 in Fig. 1b mit Lᵥ und die Induktivität der Messwicklung 22 in Fig. 1a bzw. 122 in Fig. 1b mit Lₘ bezeichnet, so gilt für einen Quotienten U₁/U₂, dass dieser gleich Lᵥ/Lₘ und damit konstant ist. Ebenfalls gilt für den Quotienten U₃/U₄, dass dieser gleich Lᵥ/Lₘ und insbesondere konstant ist, solange keiner der Magnetkerne 126, 112 in Sättigung geht. Mit anderen Worten, der Quotient U₁/U₂ bzw. U₃/U₄ ist unabhängig von dem eingeprägten elektrischen Signal I(t). Geht nun der zu überwachende Magnetkern 12 bzw. 112 in Sättigung, nimmt die an der Messwicklung 22 bzw. 122 abfallende Spannung mit steigendem Strom ab und folglich nimmt die Induktivität Lₘ der Messwicklung 22 bzw. 122 ab. Damit ändert sich auch der Wert des Quotienten U₁/U₂ bzw. U₃/U₄ und weicht insbesondere von einem konstanten Verlauf ab.

In Fig. 2a ist der Verlauf des Quotienten U₁/U₂ bzw. U₃/U₄ schematisch gegen den Strom I aufgetragen. Wie aus Fig. 2a hervorgeht, ist der Quotient U₁/U₂ bzw. U₃/U₄ unterhalb der Sättigungsgrenze, d.h. für Ströme kleiner als ein Sättigungsstrom Iₛ ist der Quotient U₁/U₂ bzw. U₃/U₄ konstant. Mit einem zunehmenden Maß an Sättigung des zu überwachenden Kerns 12 bzw. 112 weicht der Betrag des Quotienten U₁/U₂ bzw. U₃/U₄ von einem konstanten Wert Q₀ ab und kann somit nach Festlegung eines Kriteriums zur Bestimmung einer Sättigung mit einer Sättigung identifiziert werden. Zum Beispiel kann eine Abweichung vom Wert Q₀ des Quotienten U₁/U2 bzw. U₃/U₄ um mehr als 10% von Q₀, vorzugsweise um mehr als 5 % oder mehr als 1 %, mit einer Sättigung des zu überwachenden Magnetkerns identifiziert werden. Dabei wird ein Wert Qs= a x Q₀ einem Sättigungsstrom gemäß einer Sättigungsstromgrenze Iₛ zugeordnet; hierbei bezeichnet der Faktor a allgemein einen Wert kleiner 1, beispielsweise liegt a in einem Bereich kleiner 0,1. In einem konkreten Beispiel kann definiert sein: Qs = 0,1 * Q₀ oder Qₛ = 0,05 * Q₀ oder Qₛ = 0,01 * Q₀. Durch Vorgabe des Wertepaares Qs, Iₛ und einem Vergleich des Quotienten U₁/U₂ bzw. U₃/U₄ gegen den Strom I kann dementsprechend das Sättigungsverhalten des zu überwachenden Magnetkerns 12 bzw. 112 auf Grundlage des Quotienten U₁/U₂ bzw. U₃/U₄ bestimmt werden.

Zusätzlich oder alternativ kann eine Bestimmung einer Sättigungsgrenze anhand eines Verlaufs eines Produkts des Quotienten U₁/U₂ mit I bzw. U₃/U₄ mit I aufgetragen gegen den Strom I bestimmt werden. Dabei zeigt sich der Eintritt in die Sättigung des zu überwachenden Kerns 12 bzw. 112 in einer Abweichung des in Fig. 2b dargestellten Verlaufs von einem linearen Zusammenhang. Ein Kriterium zur Bestimmung des Sättigungsverhaltens kann anhand eines lokalen Maximums im Verlauf des Diagramms aus Fig. 2b festgelegt werden, z.B. wird die Lage des lokalen Maximums Iₘₐₓ₁ als Sättigungsstromgrenze festgelegt. Ein lokales Maximum bezeichnet hierbei in dem in Fig. 2b gezeigten Verlauf gerade den Punkt, an dem eine Änderung in der Induktivität Lₘ durch die Stromänderung kompensiert wird. Ab dem Strom Iₘₐₓ₁ fällt eine Abnahme in der Induktivität Lₘ stärker ins Gewicht als eine Zunahme im Strom I, wodurch sich der abnehmende Verlauf im Diagramm aus Fig. 2b ergibt.

Zusätzlich oder alternativ kann eine Bestimmung des Sättigungsverhaltens anhand eines Verlaufs eines Produkts gebildet aus einem Quadrat des Stroms I und dem Quotienten U₁/U₂ bzw. einem Produkt aus dem Quadrat des Stromsignals I und dem Quotienten U₃/U₄ gegen den Strom U abgeleitet werden. Hier bedeutet eine zunehmende Sättigung eine zunehmende Abweichung in dem in Fig. 2c gezeigten Verlauf von einer Parabel. Als Kriterium für den Eintritt in die Sättigung bzw. als Sättigungsstromgrenze kann hier der Wert eines lokalen Maximums im Verlauf gewählt werden, wie z.B. Iₘₐₓ₂, was im Verlauf des Graphen in Fig. 2c ein lokales Maximum zeigt.

In verschiedenen anschaulichen Ausführungsformen der Erfindung wird ein elektrisches Signal an einer Messwicklung, z.B. an der Messwicklung 22 in Fig. 1a oder an der Messwicklung 122 in Fig. 1b, in Antwort auf ein Messsignal, z.B. den Strom I(t) in den Fig. 1a und 1b, erfasst und mit einem elektrischem Signal an einer Vergleichsinduktivität, z.B. der Vergleichsinduktivität 24 in Fig. 1a oder der Vergleichsinduktivität 124 in Fig. 1b, verglichen, um das Sättigungsverhalten eines zu überwachenden Magnetkerns (z.B. der Magnetkern 12 in Fig. 1a oder der Magnetkern 112 in Fig. 1b) zu bestimmen.

Gemäß den zu den Fig. 2a bis 2c beschriebenen beispielhaften Ausführungsformen wird der Quotient aus den elektrischen Signalen, beispielsweise der Quotient aus den elektrischen Spannungen U₁/U₂ bzw. U₃/U₄ bestimmt. Ein Kriterium zum Bestimmen einer Sättigungsgrenze kann z.B. aus einem Verlauf des Quotienten gegen das Messsignal oder aus dem Verlauf von einer aus dem Quotienten gebildeten Größe abgeleitet werden, die gegen das Messsignal aufgetragen wird.

Gemäß einem konkreten Ausführungsbeispiel werden Details zu einer Messung an einer Speicherdrossel mit zehn Windungen angegeben. Hierbei ergab sich für den Quotienten außerhalb der Sättigung: 41,10 V/ 11,13 V = 3,69. Mit zunehmenden Strom änderte sich der Quotient gemäß: 42, 88 V/ 12,24 V = 3,50 → 35,16 V /10,54 V = 3,34 → 27,55 V / 11,57 V = 2,38. Als Sättigungsgrenze wurde für den Quotient der Wert Qₛ = 3,5 gewählt, was einer Abweichung von ca. 5 % entspricht. Dies entspricht einem Sättigungsstrom Iₛ von ca. 22,05 A. Mit anderen Worten, durch die erfindungsgemäße Vorrichtung kann eine Aussteuerung der beispielhaft gemessenen Speicherdrossel im Aussteuerbereich bis 22,05 A erfolgen, wobei sich die Induktivität um weniger als 5 % ändert.

Eine Bestimmung eines Maximums in einem Verlauf entsprechend Fig. 2b führte zu einem Wert Iₘₐₓ₁ von 21,5 A. Darüberhinaus ergab sich für Iₘₐₓ₂ der Wert von 22,5 A, der mit dem 5%-Kriterium in sehr guter Näherung übereinstimmt.

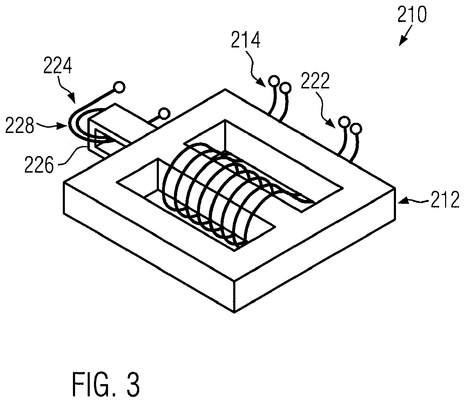

Hinsichtlich Fig. 3 wird eine Überwachung einer Speicherdrossel 210 mit einer Drosselwicklung 214 und einem Magnetkern 212 beschrieben, wobei an dem Magnetkern 212 eine Messwicklung 222 und eine Vergleichsinduktivität 224 angebracht ist. Die Vergleichsinduktivität wird durch einen zusätzlichen Magnetkern 226 und einer darauf angeordneten Wicklung 228 gebildet, wobei der zusätzliche Magnetkern derart an dem zu überwachenden Magnetkern 212 angeordnet ist, dass eine in dem zu überwachenden Magnetkern 212 durch die Vergleichsinduktivität 224 induzierte magnetische Flussdichte senkrecht zu einer von der Messwicklung 222 in dem zu überwachenden Kern induzierten magnetischen Flussdichte orientiert ist. Damit wird eine wechselseitige Beeinflussung zwischen dem Magnetkern 212 und dem Magnetkern 226 verhindert. Es wird angemerkt, dass die Messwicklung 222 mit der Wicklung 228 elektrisch in Reihe geschaltet wird, wie vorangehend hinsichtlich der Fig. 1a und 1b beschrieben ist.

Die Erfindung stellt in verschiedenen Aspekten eine Auswertung der Sättigung bzw. eine Strommessung zur Überwachung eines Magnetkerns zur Bestimmung des Sättigungsverhaltens bereit, wobei in einigen beispielhaften Ausführungsformen in einer Messwicklung und einer damit elektrisch in Reihe geschalteten Vergleichsinduktivität induzierte elektrische Spannungen mittels Quotientenbildung ausgewertet werden. Dabei liefert die Messwicklung über dem zu überwachenden Magnetkern und die Vergleichsinduktivität in Abhängigkeit der Stromflussänderung eine proportionale Ausgangsspannung, die zur Quotientenbildung verwendet wird. Wird nun die Sättigungsgrenze des zu überwachenden Magnetkerns erreicht, liefert die Messwicklung keine höhere Spannung mehr. Da die Vergleichsinduktivität hingegen immer noch eine Spannung liefert, die proportional mit dem noch steigenden Strom zunimmt, ergibt sich ein Kriterium zur Bestimmung des Sättigungsverhaltens des zu überwachenden Magnetkerns. Gemäß der vorangehend beschriebenen anschaulichen Ausführungsformen kann dementsprechend mit Hilfe der Quotientenbildung zweier unabhängiger Spannungen die Sättigungsgrenze des zu überwachenden Magnetkerns bestimmt werden. Als Bedingung gilt hierbei, dass die Vergleichsinduktivität eine höhere Sättigungsgrenze aufweist als der zu überwachende Magnetkern.

## Patentansprüche

1. Vorrichtung (10; 110; 210) zur Überwachung eines Magnetkerns (12; 112; 212), umfassend:
eine mit dem zu überwachenden Magnetkern (12; 112; 212) magnetisch gekoppelte Messwicklung (22; 122; 222);
eine zu der Messwicklung (22; 122; 222) elektrisch in Reihe geschaltete Vergleichsinduktivität (24; 124; 224); und
eine elektronische Verarbeitungseinheit (30; 130), die zur Bestimmung des Sättigungsverhaltens des zu überwachenden Magnetkerns (12; 112; 212) ausgebildet ist,
**dadurch gekennzeichnet, dass** die elektronische Verarbeitungseinheit (30; 130) dazu konfiguriert ist, in Antwort auf ein an die Messwicklung (12; 112; 212) und an die Vergleichsinduktivität (24; 124; 224) angelegtes elektrisches Messsignal ein an der Messwicklung (12; 112; 212) auftretendes erstes elektrisches Signal (U₂; U₄) und ein an der Vergleichsinduktivität (24; 124; 224) auftretendes zweites elektrisches Signal (U₁; U₃) zu erfassen und das Sättigungsverhalten des zu überwachenden Magnetkerns (12; 112; 212) auf Grundlage des ersten und zweiten elektrischen Signals (U₁, U₂; U₃, U₄) zu bestimmen.

2. Vorrichtung (10; 110; 210) nach Anspruch 1, wobei die elektronische Verarbeitungseinheit (30; 130) dazu ausgebildet ist, einen Quotienten aus dem ersten elektrischen Signal (U₂; U₄) und dem zweiten elektrischen Signal (U₁; U₃) zu bestimmen.

3. Vorrichtung (10; 110; 210) nach Anspruch 2, wobei die elektronische Verarbeitungseinheit (30; 130) dazu ausgebildet ist, eine Änderung im Quotienten um mehr als 10% von einem konstanten Wert des Quotienten (Q₀), vorzugsweise um mehr als 5% oder um mehr als 1%, mit einer Sättigung des zu überwachenden Magnetkerns (12; 112; 212) zu identifizieren.

4. Vorrichtung (10; 110; 210) nach einem der Ansprüche 1 bis 3, wobei das erste elektrische Signal eine über der Messwicklung (22; 122; 222) abfallende Spannung (U₂; U₄) und/oder das zweite elektrische Signal (U₁; U₃) eine über der Vergleichsinduktivität (24; 124; 224) abfallende Spannung ist.

5. Vorrichtung (10; 110; 210) nach einem der Ansprüche 1 bis 4, wobei die Vergleichsinduktivität (24; 124; 224) einen von dem zu überwachenden Magnetkern (12; 112; 212) verschiedenen weiteren Magnetkern (26; 126; 226) aufweist.

6. Vorrichtung (10; 110; 210) nach Anspruch 5, wobei der weitere Magnetkern (26; 126; 226) einen Sättigungsstrom aufweist, der größer ist als ein Sättigungsstrom des zu überwachenden Magnetkerns (12; 112; 212).

7. Vorrichtung (10; 110; 210) nach der Anspruch 5 oder 6, wobei die Vergleichsinduktivität (24; 124; 224) als Stromwandler ausgebildet ist.

8. Vorrichtung (10; 110; 210) nach einem der Ansprüche 5 bis 7, wobei der weitere Magnetkern (26; 126; 226) mit dem zu überwachenden Magnetkern (12; 112; 212) verbunden ist und eine in dem zu überwachenden Magnetkern (12; 112; 212) durch die Vergleichsinduktivität (24; 124; 224) induzierte magnetische Flussdichte senkrecht zu einer von der Messwicklung (22; 122; 222) in dem zu überwachenden Kern (12; 112; 212) induzierten magnetischen Flussdichte orientiert ist.

9. Verfahren zur Erfassung eines Sättigungsverhaltens eines zu überwachenden Magnetkerns (12; 112; 212) mit einer Messwicklung (22; 122; 222), wobei das Verfahren umfasst:
ein Anlegen eines elektrischen Messsignals an die Messwicklung (22; 122; 222);
ein Erfassen eines ersten elektrischen Signals (U₂; U₄) an der Messwicklung (22; 122; 222) in Antwort auf das elektrische Messsignal;
ein Erfassen eines zweiten elektrischen Signals (U₁; U₃) an einer mit der Messwicklung (22; 122; 222) elektrisch in Reihe geschalteten Vergleichsinduktivität (24; 124; 224) in Antwort auf das elektrische Messsignal; und
ein Bestimmen des Sättigungsverhaltens des zu überwachenden Magnetkerns (12; 112; 212) auf Grundlage der ersten und zweiten elektrischen Signale (U₁, U₂; U₃, U₄).

10. Verfahren nach Anspruch 9, wobei das erste elektrische Signal (U₂; U₄) als eine über der Messwicklung (22; 122; 222) abfallende elektrische Spannung und/oder das zweite elektrische Signal (U₁; U₃) als eine über der Vergleichsinduktivität (24; 124; 224) abfallende elektrische Spannung erfasst wird.

11. Verfahren nach Anspruch 9 oder 10, wobei das Sättigungsverhalten auf Grundlage eines Quotienten aus dem ersten elektrischen Signal (U₂; U₄) und dem zweiten elektrischen Signal (U₁; U₃) bestimmt wird.

12. Verfahren nach Anspruch 11, wobei eine Sättigung des zu überwachenden Magnetkerns (12; 112; 212) mit einer Änderung im Quotienten um mehr als 10% von einem konstanten Wert des Quotienten (Qo), vorzugsweise um mehr als 5% oder um mehr als 1%, identifiziert wird.

13. Verfahren nach Anspruch 11 oder 12, wobei das elektrische Messsignal ein Stromsignal ist und der Quotient in Abhängigkeit des Stromsignals erfasst wird, das Verfahren ferner umfassend ein Bilden eines Produkts aus dem Stromsignal und dem Quotienten und ein Bestimmen eines Sättigungsstroms aus einem lokalen Maximum in einem Zusammenhang zwischen dem Produkt und dem Stromsignal.

14. Verfahren nach Anspruch 11 oder 12, wobei das elektrische Messsignal ein Stromsignal ist und der Quotient in Abhängigkeit des Stromsignals erfasst wird, das Verfahren ferner umfassend ein Bilden eines Produkts aus einem Quadrat des Stromsignals und dem Quotienten und ein Bestimmen eines Sättigungsstroms aus einem lokalen Maximum in einem Zusammenhang zwischen dem Produkt und dem Stromsignal.

15. Verwendung der Vorrichtung (10; 210) nach einem der Ansprüche 1 bis 8 in einer Leistungsanwendung oder mit einem Konverter, wobei der zu überwachenden Magnetkern mit einer darüber gebildeten Wicklung (14; 214) eine Induktivität in der Leistungsanwendung oder im Konverter bildet.

## Claims

1. Apparatus (10; 110; 210) for monitoring a magnetic core (12; 112; 212), comprising:
a measurement winding (22; 122; 222) coupled with the magnetic core (12; 112; 212) to be monitored;
a comparison inductance (24; 124; 224) electrically connected in series to the measurement winding (22; 122; 222); and
an electronic processing unit (30; 130) configured to determine the saturation behavior of the magnetic core (12; 112; 212) to be monitored,
**characterized in that** the electronic processing unit (30; 130) is configured to detect a first electrical signal (U₂; U₄) occurring at the measurement winding (12; 112, 212) and a second electrical signal (U₁; U₃) occurring at the comparison inductance (24; 124; 224) in response to an electrical measurement signal applied to the measurement winding (12; 112; 212) and to the comparison inductance (24; 124; 224), and to determine the saturation behavior of the magnetic core (12; 112; 212) to be monitored on the basis of the first and the second signal (U₁, U₂; U₃, U₄).

2. Apparatus (10; 110; 210) according to claim 1, wherein the electronic processing unit (30; 130) is configured to determine a quotient from the first electrical signal (U₂; U₄) and the second electrical signal (U₁; U₃).

3. Apparatus (10; 110; 210) according to claim 2, wherein the electronic processing unit (30; 130) is configured to identify a change in the quotient by more than 10 % of a constant value of the quotient (Qo), preferably by more than 5 % or by more than 1 %, with a saturation of the magnetic core (12; 112; 212) to be monitored.

4. Apparatus (10; 110; 210) according to one of claims 1 to 3, wherein the first electrical signal is a voltage (U₂; U₄) dropping over the measurement winding (22; 122; 222) and/or the second signal (U₁; U₃) is a voltage dropping over the comparison inductance (24; 124; 224).

5. Apparatus (10; 110; 210) according to one of claims 1 to 4, wherein the comparison inductance (24; 124; 224) comprises a further magnetic core (26; 126; 226) which is different from the magnetic core to be monitored (12; 112; 212).

6. Apparatus (10; 110; 210) according to claim 5, wherein the further magnetic core (26; 126; 226) comprises a saturation current which is greater than the saturation current of the magnetic core (12; 112; 212) to be monitored.

7. Apparatus (10; 110; 210) according to claim 5 or 6, wherein the comparison inductance (24; 124; 224) is configured as current transformer.

8. Apparatus (10; 110; 210) according to claims 5 to 7, wherein the further magnetic core (26; 126; 226) is connected to the magnetic core (12; 112; 212) to be monitored and a magnetic flux density induced by the comparison inductance (24; 124; 224) in the magnetic core (12; 112; 212) to be monitored is oriented perpendicularly to a flux density induced by the measurement winding (22; 122; 222) in the core (12; 112; 212) to be monitored.

9. Method for detecting a saturation behavior of a magnetic core (12; 112; 212) to be monitored with a measurement winding (22; 122; 222), the method comprising:
applying an electrical measurement signal to the measurement winding (22; 122; 222);
detecting a first electrical signal (U₂; U₄) at the measurement winding (22; 122; 222) in response to the electrical measurement signal;
detecting a second electrical signal (U₁; U₃) at a comparison inductance (24; 124; 224) electrically connected in series with the measurement winding (22; 122; 222) in response to the electrical measurement signal; and
determining the saturation behavior of the magnetic core (12; 112; 212) to be monitored on the basis of the first and second electrical signals (U₁, U₂; U₃, U₄).

10. Method according to claim 9, wherein the first electrical signal (U₂; U₄) is detected as an electrical voltage dropping over the measurement winding (22; 122; 222) and/or the second electrical signal (U₁; U₃) as an electrical voltage dropping over the comparison inductance (24; 124; 224).

11. Method according to claim 9 or 10, wherein the saturation behavior is determined on the basis of a quotient from the first electrical signal (U₂; U₄) and the second electrical signal (U₁; U₃).

12. Method according to claim 11, wherein a saturation of the magnetic core (12; 112; 212) to be monitored is identified with a change in quotient by more than 10 % of a constant value of the quotient (Qo), preferably by more than 5 % or more than 1 %.

13. Method according to claim 11 or 12, wherein the electrical measurement signal is a current signal and the quotient is detected in dependence on the current signal, the method further comprising forming a product from the current signal and the quotient and determining a saturation behavior from a local maximum in an interrelation between the product and the current signal.

14. Method according to claim 11 or 12, wherein the electrical measurement signal is a current signal and the quotient is detected in dependence on the current signal, the method further comprising forming a product from a square of the current signal and the quotient and determining a saturation current from a local maximum in an interrelation between the product and the current signal.

15. Application of the apparatus (10; 210) according to one of claims 1 to 8 in a power application or with a transformer, wherein the magnetic core to be monitored forms an inductance in the power application or in the transformer with a winding (14; 214) formed over the magnetic core.

## Revendications

1. Dispositif (10 ; 110 ; 210) permettant de surveiller un noyau magnétique (12 ; 112 ; 212), comprenant :
un enroulement de mesure (22; 122; 222) couplé magnétiquement au noyau magnétique (12 ; 112 ; 212) à surveiller ;
une inductance de comparaison (24 ; 124 ; 224) connecté électriquement en série avec l'enroulement de mesure (22 ; 122 ; 222) ; et
une unité de traitement électronique (30 ; 130) conçue pour déterminer le comportement de saturation du noyau magnétique (12 ; 112 ; 212) à surveiller,
**caractérisé en ce que** l'unité de traitement électronique (30 ; 130) est configurée pour détecter, en réponse à un signal de mesure électrique appliqué à l'enroulement de mesure (12 ; 112 ; 212) et à l'inductance de comparaison (24 ; 124 ; 224), un premier signal électrique (U₂ ; U₄) se produisant au niveau de l'enroulement de mesure (12 ; 112; 212) et un second signal électrique (U₁; U₃) se produisant au niveau de l'inductance de comparaison (24 ; 124 ; 224), et pour déterminer le comportement de saturation du noyau magnétique (12 ; 112 ; 212) à surveiller en se basant sur les premier et second signaux électriques (U₁, U₂ ; U₃, U₄).

2. Dispositif (10 ; 110 ; 210) selon la revendication 1, dans lequel l'unité de traitement électronique (30 ; 130) est conçue pour déterminer un quotient issu du premier signal électrique (U₂ ; U₄) et du second signal électrique (U₁ ; U₃).

3. Dispositif (10 ; 110 ; 210) selon la revendication 2, dans lequel l'unité de traitement électronique (30 ; 130) est conçue pour identifier une variation du quotient de plus de 10%, de manière préférée de plus de 5% ou de plus de 1%, par rapport à une valeur constante du quotient (Qₒ) avec une saturation du noyau magnétique (12 ; 112 ; 212) à surveiller.

4. Dispositif (10 ; 110 ; 210) selon l'une quelconque des revendications 1 à 3, dans lequel le premier signal électrique est une tension (U₂ ; U₄) chutant aux bornes de l'enroulement de mesure (22 ; 122 ; 222) et/ou le second signal électrique (U₁ ; U₃) est une tension chutant aux bornes de l'inductance de comparaison (24 ; 124 ; 224).

5. Dispositif (10 ; 110 ; 210) selon l'une quelconque des revendications 1 à 4, dans lequel l'inductance de comparaison (24 ; 124 ; 224) présente un autre noyau magnétique (26 ; 126; 226) différent du noyau magnétique (12 ; 112; 212) à surveiller.

6. Dispositif (10 ; 110; 210) selon la revendication 5, dans lequel l'autre noyau magnétique (26 ; 126; 226) présente un courant de saturation supérieur à un courant de saturation du noyau magnétique (12 ; 112 ; 212) à surveiller.

7. Dispositif (10 ; 110 ; 210) selon la revendication 5 ou 6, dans lequel l'inductance de comparaison (24 ; 124 ; 224) est réalisée sous la forme d'un transformateur de courant.

8. Dispositif (10 ; 110 ; 210) selon l'une quelconque des revendications 5 à 7, dans lequel l'autre noyau magnétique (26 ; 126 ; 226) est relié au noyau magnétique (12 ; 112 ; 212) à surveiller, et une densité de flux magnétique induite grâce à l'inductance de comparaison (24 ; 124 ; 224) dans le noyau magnétique (12 ; 112; 212) à surveiller est orientée perpendiculairement à une densité de flux magnétique induite par l'enroulement de mesure (22 ; 122; 222) dans le noyau (12; 112; 212) à surveiller.

9. Procédé de détection d'un comportement de saturation d'un noyau magnétique (12 ; 112 ; 212) à surveiller avec un enroulement de mesure (22 ; 122 ; 222), dans lequel le procédé comprend les étapes consistant à :
appliquer un signal de mesure électrique à l'enroulement de mesure (22 ; 122 ; 222) ;
détecter un premier signal électrique (U₂ ; U₄) au niveau de l'enroulement de mesure (22 ; 122 ; 222) en réponse au signal de mesure électrique ;
détecter un second signal électrique (U₁ ; U₃) au niveau d'une inductance de comparaison (24 ; 124 ; 224) connectée électriquement en série avec l'enroulement de mesure (22 ; 122 ; 222) en réponse au signal de mesure électrique ; et
déterminer le comportement de saturation du noyau magnétique (12 ; 112 ; 212) à surveiller en se basant sur les premier et second signaux électriques (U₁, U₂ ; U₃, U₄).

10. Procédé selon la revendication 9, dans lequel le premier signal électrique (U₂ ; U₄) est détecté sous la forme d'une tension électrique chutant aux bornes de l'enroulement de mesure (22 ; 122 ; 222) et/ou le second signal électrique (U₁ ; U₃) est détecté sous la forme d'une tension électrique chutant aux bornes de l'inductance de comparaison (24 ; 124 ; 224).

11. Procédé selon la revendication 9 ou 10, dans lequel le comportement de saturation est déterminé en se basant sur un quotient issu du premier signal électrique (U₂ ; U₄) et du second signal électrique (U₁ ; U₃).

12. Procédé selon la revendication 11, dans lequel une saturation du noyau magnétique (12 ; 112 ; 212) à surveiller avec une variation du quotient de plus de 10%, de manière préférée de plus de 5% ou de plus de 1%, par rapport à une valeur constante du quotient (Qₒ) est identifiée.

13. Procédé selon la revendication 11 ou 12, dans lequel le signal de mesure électrique est un signal de courant et le quotient est détecté en fonction du signal de courant, le procédé comprenant en outre les étapes consistant à former un produit issu du signal de courant et du quotient et à déterminer un courant de saturation à partir d'un maximum local dans une relation entre le produit et le signal de courant.

14. Procédé selon la revendication 11 ou 12, dans lequel le signal de mesure électrique est un signal de courant et le quotient est détecté en fonction du signal de courant, le procédé comprenant en outre les étapes consistant à former un produit issu du carré du signal de courant et du quotient, et à déterminer un courant de saturation à partir d'un maximum local dans une relation entre le produit et le signal de courant.

15. Utilisation du dispositif (10 ; 210) selon l'une quelconque des revendications 1 à 8 dans une application de puissance ou avec un convertisseur, dans lequel le noyau magnétique à surveiller forme avec un enroulement (14 ; 214) formé sur celui-ci une inductance au sein de l'application de puissance ou du convertisseur.
